# DEMANDE DE BREVET EUROPEEN

(11) **EP 0 660 386 A1**
(43) Date de publication de la demande: **28.06.1995**
(21) Numéro de dépôt: 94410111.2
(22) Date de dépôt: 26.12.1994
(51) Int. Cl.: H01L 21/66, H01L 23/485

(54) **Structure de test de circuit intégré**

(30) Priorité: 27.12.1993 FR 9315995
(71) Demandeur: SGS-THOMSON MICROELECTRONICS S.A., F-94250 Gentilly (FR)
(72) Inventeur: Smears, Nicholas William, F-38120 Saint Egreve (FR)
(74) Mandataire: de Beaumont, Michel

(57) **Abrégé**

La présente invention concerne un circuit intégré dont au moins un plot d'accès (1) est relié à un élément (4) d'un circuit interne (3) par l'intermédiaire d'un condensateur constitué de deux portions de couches conductrices en regard isolées entre elles. La portion de couche conductrice inférieure (21) est reliée au plot et la portion de couche conductrice supérieure (25) est reliée audit élément. Ainsi la portion de couche conductrice supérieure (25) peut former un plot de test en courant continu.

## Description

La présente invention concerne des circuits intégrés comprenant des entrées capacitives sur lesquelles on veut pouvoir effectuer des opérations de test en courant continu.

Plus particulièrement, la présente invention concerne des circuits intégrés dans lesquels certains au moins des plots d'entrée sont couplés à des circuits internes du circuit intégré par l'intermédiaire de condensateurs. Ceci est le cas de circuits intégrés recevant des signaux haute fréquence, par exemple des circuits utilisés pour des émetteurs-récepteurs de radiotéléphone qui reçoivent des signaux à très haute fréquence, de l'ordre de plusieurs centaines de MHz, et traitent notamment des signaux à fréquence intermédiaire de plusieurs MHz.

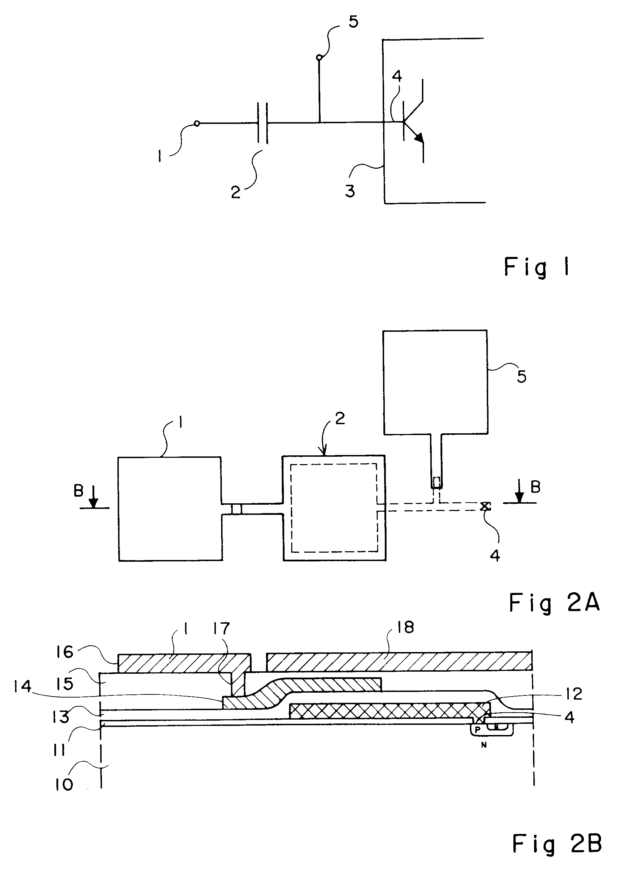

Comme le représente la figure 1, un plot 1 de circuit intégré est couplé par l'intermédiaire d'un condensateur 2 à l'entrée d'un circuit interne 3, et est par exemple connecté à la base 4 d'un transistor bipolaire.

Lors de la fabrication de circuits intégrés, les fabricants soucieux de fournir des circuits sans défauts prévoient de nombreuses étapes de test. Certains de ces tests sont réalisés alors que le circuit intégré n'est pas encore encapsulé en appliquant sur la surface supérieure de la puce, éventuellement non encore séparée des autres puces d'une même plaquette, des pointes ou moustaches conductrices permettant de fournir et/ou de recevoir des signaux de test. Dans le cas du plot de la figure 1, on souhaite lors des tests pouvoir appliquer des signaux continus aux circuits internes pour étudier la réaction de ces circuits. Pour cela, il faut prévoir un accès supplémentaire au circuit, constitué par exemple par une borne 5 qui correspond usuellement à un plot supplémentaire.

La figure 2A représente en vue de dessus un exemple de réalisation classique de la portion de circuit intégré illustrée en figure 1 comprenant le plot d'entrée 1, le condensateur 2, la connexion vers un circuit interne 3 et le plot de test 5. Le condensateur est réalisé par la superposition de deux couches conductrices en regard séparées par une couche isolante.

Comme le représente la vue en coupe de la figure 2B, la structure de la figure 2A est réalisée au-dessus d'un substrat 10 dans lequel sont réalisées les implantations et diffusions nécessaires à la constitution des composants du circuit intégré. Ce substrat est revêtu d'une première couche isolante 11, couramment de l'oxyde de silicium, qui recouvre entièrement le substrat sauf aux emplacements où l'on veut établir des contacts avec des portions de couches sélectionnées. Par exemple, on a représenté très schématiquement dans la partie inférieure droite de la figure une structure de transistor NPN pour laquelle on veut établir un contact de base 4 correspondant à l'entrée du circuit 3 représenté en figure 1. Une première couche conductrice 12 est formée sur la couche isolante 11 et, dans l'exemple représenté, est gravée pour constituer l'électrode inférieure du condensateur 2 et la liaison vers la région de base 4 du transistor NPN. La première couche conductrice 12 est recouverte d'une deuxième couche isolante 13 qui peut être planarisée ou non. Elle a été représentée dans la figure comme non planarisée. Une deuxième couche conductrice 14 est ensuite déposée sur la couche isolante 13 et est gravée pour constituer l'électrode supérieure du condensateur 2. Des portions de cette couche conductrice 14 pourraient également servir à la réalisation de plots. Toutefois, dans l'exemple représenté, on a illustré cette couche conductrice 14 comme recouverte d'une troisième couche isolante 15, planarisée, elle-même recouverte d'une troisième couche conductrice 16 dont des portions servent à la réalisation des plots 1 et 5. Le plot 1 est relié par un via 17 à une extension de la portion de couche conductrice 14 de deuxième niveau servant à la réalisation de l'électrode supérieure du condensateur. De même, le plot 5, qui n'apparaît pas en figure 2B, est relié par un via non représenté à une extension de la couche d'électrode inférieure du condensateur. Généralement, dans les circuits intégrés destinés à traiter des signaux haute fréquence, la troisième couche conductrice est également maintenue sur une très large portion 18 qui recouvre l'ensemble de la structure, à l'exception des plots, et qui sert de blindage, cette portion étant par exemple reliée à un plot de masse.

Des structures de ce type sont très largement utilisées dans la pratique.

Quand on regarde une puce de circuit intégré non encore encapsulée, on voit qu'une partie très importante de la surfaoe de la puce est occupée par les plots de connexion. En effet, les composants élémentaires du circuit intégré ont couramment des dimensions de l'ordre de quelques µm² alors qu'un plot, pour permettre une soudure ou un test, doit avoir des dimensions de l'ordre de la dizaine de milliers de µm² (par exemple 100 µm x 100 µm). C'est donc un souci permanent des fabricants de circuits intégrés de limiter le nombre de plots d'un circuit intégré. On souhaite tout particulièrement limiter au maximum le nombre de plots qui ne servent qu'aux tests et ne sont pas utilisés ensuite pour connecter le circuit.

On voit que dans la structure décrite précédemment, la prévision d'un plot de test 5 pour appliquer par des pointes des signaux continus sur la base du transistor NPN est indispensable puisqu'il n'est pas possible d'accéder à la connexion vers la base du transistor pour les trois raisons suivantes :
- cette connexion est trop étroite,
- cette connexion se situe à un niveau de couche conductrice trop bas et recouvert de couches isolantes,
- cette connexion est recouverte par une couche de blindage.

Ainsi, on a toujours utilisé dans la technique de tels plots de test supplémentaires 5 pour permettre la réalisation de tests sous pointes en courant continu d'un circuit intégré à accès capacitif.

Un objet de la présente invention est de réduire la surfaoe d'un circuit intégré du type susmentionné.

Un objet plus particulier de la présente invention est de permettre le test d'un circuit intégré du type susmentionné sans utiliser de plots de test spécifiques.

Pour atteindre ces objets, la présente invention prévoit fondamentalement d'inverser l'ordre usuel de positionnement des électrodes du condensateur d'entrée, et de prévoir comme électrode supérieure l'électrode reliée aux connexions internes du circuit et comme électrode inférieure l'électrode connectée au plot d'entrée. Il est alors possible de réaliser le test en utilisant l'électrode supérieure du condensateur comme plot d'accès à une pointe portant des signaux de test en courant continu. S'il est prévu une couche de blindage, cette couche de blindage est interrompue autour du condensateur d'entrée et la portion située au-dessus de ce condensateur est reliée à l'électrode supérieure du condensateur.

Plus particulièrement, la présente invention prévoit un circuit intégré dont au moins un plot d'accès est relié à un élément d'un circuit interne par l'intermédiaire d'un condensateur constitué de deux portions de couches conductrioes en regard isolées entre elles. La portion de couche conductrice inférieure est reliée au plot et la portion de couche conductrice supérieure est reliée audit élément.

La portion de couche conductrice supérieure forme un plot de test.

Selon un mode de réalisation de la présente invention, la portion de couche conductrice inférieure est du silicium polycristallin et la portion de couche conductrice supérieure correspond à un premier niveau de métallisation. La portion de couche conductrice formant l'électrode supérieure du condensateur est de préférence surmontée d'une couche isolante et d'une portion d'une troisième couche conductrice qui lui est connectée par des trous de passage à travers ladite couche isolante.

Selon un mode de réalisation de la présente invention, la portion de couche conductrice inférieure est du silicium polycristallin et la portion de couche conductrice supérieure correspond à une région diffusée reliée à une portion de couche d'un premier niveau de métallisation. De préférence, la portion de premier niveau de métallisation est surmontée d'une portion d'une portion d'une couche conductrice d'un deuxième niveau de métallisation qui lui est connectée.

Ces objets, caractéristiques, avantages ainsi que d'autres de la présente invention seront exposés en détail dans la description suivante de modes de réalisation particuliers faite, à titre non limitatif, en relation avec les figures jointes parmi lesquelles :
la figure 1, décrite précédemment, représente sous forme de circuit un accès capacitif à un circuit intégré ;
les figures 2A et 2B, décrites précédemment, représentent respectivement une vue de dessus et une vue en coupe schématique d'une portion de circuit intégré classique correspondant à la figure 1 ;
la figure 3 représente en vue de dessus un mode de réalisation selon la présente invention d'une portion de circuit intégré ;
les figures 4A et 4B représentent respectivement une vue de dessus et une vue en coupe schématique d'un premier mode de réalisation d'une portion de circuit intégré selon la présente invention ; et
la figure 5 représente une vue en coupe schématique d'un deuxième mode de réalisation d'une portion de circuit intégré selon la présente invention.

On notera que, conformément à l'usage, les diverses figures représentant des portions de circuit intégré ne sont tracées à l'échelle. Au contraire, les dimensions des divers éléments sont arbitrairement rétrécies ou élargies pour améliorer la lisibilité des figures et simplifier leur dessin.

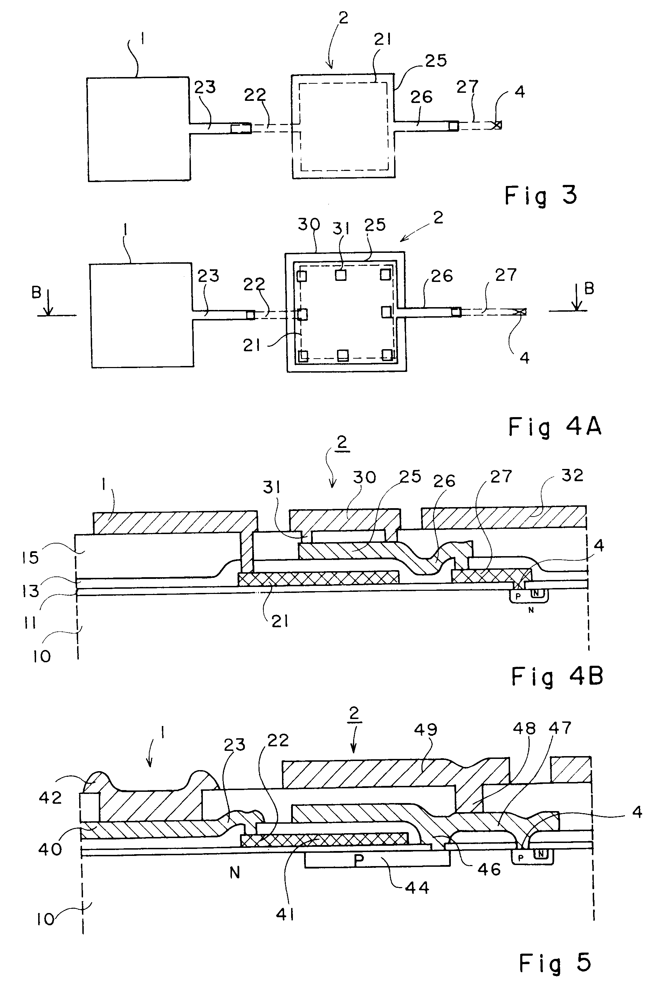

La figure 3 représente une vue de dessus d'un mode de réalisation selon la présente invention d'un plot de circuit intégré 1 relié à un contact d'accès 4 vers un composant du circuit intégré, par exemple la base d'un transistor NPN, par l'intermédiaire d'un condensateur 2.

Le condensateur 2 est réalisé de sorte que son électrode inférieure 21 est reliée par un prolongement 22 à un prolongement 23 du plot 1. L'électrode supérieure 25 du condensateur est reliée par l'intermédiaire d'un prolongement 26 au contact 4 vers le composant ou bien à une portion d'une autre couche conductrice 27 liée à ce contact 4.

Classiquement, l'électrode 21 correspondra à un premier niveau de couche conductrice, par exemple une couche de silicium polycristallin ; l'électrode 25 correspondra à un deuxième niveau de couche conductrice, par exemple un premier niveau de métallisation ; et le plot 1 correspondra à un troisième niveau de couche conductrice, par exemple un deuxième niveau de métallisation. Bien entendu, cette réalisation est susceptible de nombreuses variantes, le condensateur peut être réalisé entre des premier et deuxième niveaux de métallisation, et le plot peut correspondre au même niveau de métallisation que l'électrode supérieure.

Grâce à cette configuration, et au choix d'un niveau de métallisation supérieure pour la réalisation de l'électrode du condensateur qui est reliée à au moins un composant interne du circuit intégré, il est possible d'utiliser cette électrode supérieure directement comme plot de test.

Si l'électrode 25 est réalisée au niveau d'une portion d'une couche conductrice supérieure qui n'est pas la couche conductrioe la plus haute du circuit intégré, cette couche conductrice la plus haute, selon un mode de réalisation de la présente invention, sera ouverte au-dessus de cette électrode supérieure pour lui permettre de servir de plot de test.

Selon un premier mode de réalisation de la présente invention illustré en vue de dessus en figure 4A et en vue en coupe en figure 4B, l'électrode inférieure du condensateur est constituée d'une portion d'une couche conductrice de silicium polycristallin, l'électrode supérieure est constituée d'une portion d'une couche conductrice de premier niveau de métallisation et est elle-même revêtue d'une portion sensiblement conforme d'une couche conductrice de deuxième niveau de métallisation qui lui est connectée.

Plus particulièrement, la figure 4A représente le plot d'entrée 1, son prolongement servant de connexion 23 relié à un prolongement servant de connexion 22 d'une portion de couche de silicium polycristallin 21 constituant l'électrode inférieure du condensateur. Une portion 25 de couche de premier niveau de métallisation recouvre par l'intermédiaire d'une couche isolante l'électrode 21 et se prolonge par une connexion 26 vers un accès 4 au circuit intégré ou vers un prolongement 27 d'une connexion en silicium polycristallin assurant le contact avec cet accès. Une couche métallique supérieure 30 constituant une portion de couche de deuxième niveau de métallisation est reliée par des vias 31 à l'électrode supérieure 25.

On retrouve les éléments susmentionnés en figure 4B qui est une vue en coupe selon la ligne B-B de la figure 4A. Les éléments sont formés au-dessus d'un substrat 10 associé à des première, deuxième et troisième couches isolantes 11, 13 et 15. On voit en outre en figure 4B une portion supplémentaire de couche conductrice du deuxième niveau de métallisation 32 servant de blindage électromagnétique à l'ensemble du circuit intégré à l'exception des régions de plot et des régions supérieures des condensateurs. Cette structure présente l'avantage d'améliorer la résistance mécanique entre le circuit intégré et le contact formé par une pointe de test au-dessus du condensateur sur la couche 30.

Selon un autre mode de réalisation de la présente invention illustré en vue en coupe en figure 5, l'électrode inférieure du condensateur est constituée d'une région diffusée. L'électrode supérieure est constituée d'une portion d'une couche conductrice de silicium polycristallin, et est elle-même revêtue de portions sensiblement conformes de couches conductrices de premier et de deuxième niveaux de métallisation qui lui sont connectées. Ainsi, l'électrode inférieure se retrouve en position d'électrode supérieure.

Plus particulièrement, en figure 5, le plot d'entrée 1 est constitué d'une portion 40 d'un premier niveau de métallisation munie d'un prolongement servant de connexion 23 relié à un prolongement servant de connexion 22 d'une portion de couche de silicium polycristallin 41 constituant une première électrode du condensateur. La portion 40 de premier niveau de métallisation est revêtue d'une portion 42 de deuxième niveau de métallisation constituant le plot 1. Dans le substrat 10, sous la portion de couche de silicium polycristallin 41, est disposée une région diffusée 44 constituant la deuxième électrode du condensateur. Cette région 44 est relié par un via 46 à une portion 47 de couche de premier niveau de métallisation. La portion 47 se prolonge vers un accès 4 au circuit intégré. Une couche métallique supérieure 49 constituant une portion de couche de deuxième niveau de métallisation est reliée par des vias 48 à la portion 47 et constitue in fine l'électrode supérieure du condensateur pouvant servir de plot de test.

Couramment, les capacités d'entrée comprises entre des plots d'accès et des circuits internes de circuit intégré ont des valeurs de l'ordre de la dizaine de nF et occupent une surface correspondant sensiblement à un carré ayant un côté d'une dimension de 50 à 100 µm.

L'homme de métier notera que l'invention est susceptible de nombreuses variantes, son aspect fondamental résidant dans l'inversion de la disposition usuelle des connexions des électrodes haute et basse d'un condensateur d'accès et dans l'utilisation de l'électrode haute comme point de test.

Par ailleurs, la présente invention a été décrite dans le cadre de circuits intégrés bipolaires. Elle s'applique aussi à des circuits de type BICMOS ou MOS. Toutefois, à l'heure actuelle, pour les circuits haute fréquence tels que les circuits d'émetteur/récepteur de radiotéléphonie, on utilise essentiellement des circuits intégrés bipolaires. D'autre part, bien que l'on ait parlé de première couche de silicium polycristallin, et de premier et deuxième niveaux de métallisation, les trois niveaux de couche conductrice pourront être réalisés de toute autre manière adaptée à la technologie du circuit intégré considéré et plus de trois niveaux de couches conductrices pourront être utilisés.

## Revendications

1. Circuit intégré dont au moins un plot d'accès (1) est relié à un élément (4) d'un circuit interne (3) par l'intermédiaire d'un condensateur constitué de deux portions de couches conductrices en regard isolées entre elles, caractérisé en ce que la portion de couche conductrice inférieure (21) est reliée au plot et la portion de couche conductrice supérieure (25) est reliée audit élément.

2. Circuit intégré selon la revendication 1, caractérisé en ce que la portion de couche conductrice supérieure (25) forme un plot de test.

3. Circuit intégré selon la revendication 2, caractérisé en ce que la portion de couche conductrice inférieure (21) est du silicium polycristallin et la portion de couche conductrice supérieure (25) correspond à un premier niveau de métallisation.

4. Circuit intégré selon la revendication 3, caractérisé en ce que la portion de couche conductrice (25) formant l'électrode supérieure du condensateur est surmontée d'une couche isolante et d'une portion d'une troisième couche conductrice (30) qui lui est connectée par des trous de passage (31) à travers ladite couche isolante.

5. Circuit intégré selon la revendication 2, caractérisé en ce que la portion de couche conductrice inférieure (41) est du silicium polycristallin et la portion de couche conductrioe supérieure correspond à une région diffusée (44) reliée à une portion (47) d'un premier niveau de métallisation.

6. Circuit intégré selon la revendication 5, caractérisé en ce que la portion (47) de premier niveau de métallisation est surmontée d'une portion d'une couche conductrice (49) d'un deuxième niveau de métallisation qui lui est connectée.
